# EUROPEAN PATENT SPECIFICATION

(11) **EP 2 722 875 B1**
(45) Date of publication and mention of the grant of the patent: **19.05.2021**
(21) Application number: 13189674.8
(22) Date of filing: 22.10.2013
(51) Int. Cl.: H01L 21/66, H01L 23/00

(54) **Flip chip device and method of manufacturing therefor**
Flip-Chip Vorrichtung und Herstellungsverfahren dafür
Dispositif de puce retournée et procédé de fabriation associé

(30) Priority: 22.10.2012 WO PCT/CN2012/083282
(43) Date of publication of application: 23.04.2014
(73) Proprietor: Spreadtrum Communications (Shanghai) Co., Ltd., Shanghai 201203 (CN)
(72) Inventor: Zhou, Xinshu, Shanghai 201203 (CN)
(74) Representative: Eisenführ Speiser

(56) References cited:
- EP-A2- 0 767 492
- US-A1- 2006 066 327
- US-A1- 2008 012 046
- US-A1- 2008 308 798
- US-B1- 6 251 694

## Description

### FIELD OF THE INVENTION

Embodiments of the present invention generally relate to the field of electrical testing of the flip chip, and more particularly, to the structure and arrangement of bonding pads on a flip chip and to a corresponding manufacturing method.

### BACKGROUND OF THE INVENTION

Generally speaking, a semiconductor device is produced through a series of processes such as manufacturing, electrical die sorting (EDS) and packaging. The EDS process is used to test various electrical characteristics of the semiconductor wafer. During the EDS process, the chips with and without defects may be separated from each other. If the defects may be repaired or fixed, the chips will go through a repair procedure for later use. On the other hand, for those chips on which the defects cannot be fixed, the wafers will be discarded. By use of the EDS process, the productivity in the packaging process may be significantly improved and the costs and time may be reduced.

The EDS process may use various probe devices, like probe cards, to test the electrical characteristics of the chips. A probe card is equipped with one or more tips for contacting the bonding pads on a chip to detect any defects. Commonly-used probe cards can be classified into the cantilever type and the vertical type. In general, a cantilever probe card is applicable to a wafer where the pads are located proximate to the edge of chips or dies, the pads are formed in four or less rows, the pad area is approximately 40×40µm, and the inline and stagger pitches between the pads are no less than 30µm and 60µm, respectively. The cantilever probe cards have excellent performances, for example, for those chips on which the pads are located proximate to the edges.

A vertical probe card is generally applicable to a wafer where the pads may be located at any positions on the dies. The vertical probe card may have flat tips or point tips. The point tips may be used when the pitch between pads are more than 80µm, and the flat tips may be used when the pitch between pads are more than 100µm. The vertical probe card with flat tips is usually more cost effective than the one with point tips because the flat tips usually have longer life time.

With the integrated circuits becoming smaller in size and higher in speed, it is sometimes difficult to apply wire bonding technology in packaging chips with a great number of input/output. Accordingly, attention has been drawn to the flip chip packaging technology. As know, a flip chip may include bumps in the form of solders or copper columns. For solder or lead-free (LF) bumps, the pitch between two bumps is generally more than 150µm, to which the vertical probe card may be applicable. If the pitch between the centers of two bumps are less than 150µm, a copper column(s) may be added between the solder and the under bump metal (UBM) to enhance the reliability. For copper column bumps, the pitch between bumps may be at the level of 80µm.

In testing the flip chips using the probe cards, a problem to be addressed is the probe marks on the pads left behind the probe tips. More specifically, when a probe card is used to test the electrical characteristics before bumping, the probe will inevitably leave some marks on the contact areas on the pads during operation, and these marks in turn degrade the performance and/or reliability of the chips. For example, for solder bumps, the probe marks may cause one or more voids between the bumps and the UBM, which will weaken the coupling strength and make the bumps displace or even drop during solder reflow procedure. For copper bumps, the strong stress in the UBM plating process is very likely to crash the copper columns down or cause crakes in the passivation layer.

In view of the foregoing, there is a need in the art for new solutions for testing the pads on flip chips using probe cards while estimating the problems caused by the probe marks.

US 2006/0066327 A1 describes an interface assembly and method for testing a semiconductor wafer prior to performing a flip chip bumping process. The interface assembly includes a flip chip bonding pad having a region for performing the bumping process. A test pad is integrally constructed with the bonding pad and includes a probe region for performing wafer-level testing prior to performing the bumping process.

US 6,251,694 B1 provides a method of testing and packaging a semiconductor chip. The semiconductor chip includes an integrated circuit (IC) positioned within the semiconductor chip, and a bonding pad positioned on the surface of the semiconductor chip and electrically connected with the IC.

EP 0 767 492 A2 describes an integrated circuit test system. Die are fabricated using a technique commonly known as "flip-chip". The die are then tested in a test device. Only a subset of the contact pads on the flip-chip are used in the testing process.

US 2008/0012046 A1 describes a semiconductor device including a first pad, a second pad and a third pad. The first pad and the third pad are electrically connected to each other. The first pad and the second pad are used for bonding. The second pad and the third pad are used for probing By arranging the first pad on an I/O buffer, the area where only a pad is formed is reduced so that the chip size can be reduced. The second pad and the third pad are not arranged on the I/O buffer and an interconnection. In an example, an arrangement of the first pad and arrangement of the second pad are taken as a matrix having rows and columns. For example, in a case where the first pads and the second pads are arranged respectively in rows, a row on which the first pads are arranged and a row on which the second pads are arranged do not overlap and being parallel to each other.

US 2008/0308798 A1 describes a semiconductor device in which size reduction is possible without functional devices below pads being damaged by stress. The semiconductor device has a plurality of pads above a semiconductor substrate as terminals for external connection. A plurality of dual use pads which are used in both a probing test and assembly are provided in a first area above a main surface of the semiconductor substrate.

### SUMMARY OF THE INVENTION

To solve the above and other potential problems in the prior art chip probe, embodiments of the present invention provide new solutions for probing the pads in a flip chip.

In the first aspect, the present invention provides a flip chip. The flip chip comprises a first set of pads, each pad of the first set of pads comprising a first pad portion configured for only contact with one or more tips of a probe device during a testing before bumping on the pad of the first set of pads, and a second pad portion configured for only the bumping on the pad of the first set of pads without contact with the one or more tips during the testing, a second set of pads, each pad of the second set of pads configured for only bumping on the pad of the second set of pads after the testing; and a third set of pads, each pad of the third set of pads configured for only contact with one or more tips of the probe device during the testing, wherein the first pad portions and the pads of the third set of pads have probe marks but no solder bumps thereon, and the second pad portions and the pads of the second set of pads have solder bumps but no probe marks thereon, wherein the first set of pads are formed in first and second rows and a part of a third row in a first area of the flip chip that is proximate to an edge of the flip chip, the second set of pads are formed in a fourth row in a second area of the flip chip that is further from the edge than the first area, and the third set of pads are formed in a fifth row and another part of the third row in a third area of the flip chip between the first and second areas, wherein the first and second rows are proximate to the edge, wherein the fourth row is further from the edge than the first and second rows, and wherein the third row is disposed between the second row and the fifth row, and the fifth row is disposed between the third row and the fourth row.

In the second aspect, the present invention provides a method for manufacturing a flip chip. The method comprises forming a first set of pads on the flip chip, wherein forming each pad of the first set of pads comprises providing a first pad portion of the pad configured for only contact with one or more tips of a probe device during a testing before bumping on the pad of the first set of pads; and providing a second pad portion of the pad configured for only the bumping on the pad of the first set of pads without contact with the one or more tips during the testing; forming a second set of pads on the flip chip, each pad of the second set of pads configured for only bumping on the pad of the second set of pads after the testing; and forming a third set of pads on the flip chip, each pad of the third set of pads configured for only contact with one or more tips of the probe device during the testing, testing the flip chip, thereby causing probe marks on the first pad portions and the pads of the third set of pads but not on the second pad portions and not on the pads of the second set of pads, and after the testing, forming solder bumps on the second pad portions and the pads of the second set of pads but not on the first pad portions and not on the pads of the third set of pads, wherein the first set of pads are formed in first and second rows and a part of a third row in a first area of the flip chip that is proximate to an edge of the flip chip, the second set of pads are formed in a fourth row in a second area of the flip chip that is further from the edge than the first area, and the third set of pads are formed in a fifth row and another part of the third row in a third area of the flip chip between the first and second areas, wherein the first and second rows are proximate to the edge, wherein the fourth row is further from the edge than the first and second rows, and wherein the third row is disposed between the second row and the fifth row, and the fifth row is disposed between the third row and the fourth row.

As summarized above and detailed below, a pad on the flip chip may be divided into two portions, one portion used for contact with the probe tips during the testing, while the other portion used for bumping without contact with the probe tips. In this way, the EDS process may be effectively carried out before packaging the chips, and in the meantime, those potential problems caused by probe marks on the pads may be avoided because the portion on the pad that is used for bumping is free of any probe marks. As such, both the productivity and the reliability of package may be ensured.

Other features and advantages of embodiments of the present invention will also be understood from the following description of specific exemplary embodiments when read in conjunction with the accompanying drawings, which illustrate, by way of example, the principles of the invention.

### BRIEF DESCRIPTION OF THE DRAWINGS

Embodiments of the invention will be presented in the sense of examples and their advantages are explained in greater detail below, with reference to the accompanying drawings, wherein:
FIG. 1 shows the schematic top view of a pad on a flip chip in accordance with examples useful for understanding the present invention;
FIG. 2 shows the schematic top view of a flip chip in accordance with exemplary embodiments of the present invention;
FIG. 3 shows the schematic top view of the flip chip as shown in FIG. 2 where traces have been routed;
FIG. 4 shows the flowchart of a method for manufacturing a pad on a flip chip in accordance with examples useful for understanding the present invention; and
FIG. 5 shows the flowchart of part of a method for manufacturing a flip chip in accordance with exemplary embodiments of the present invention.

Throughout the figures, same or similar reference numbers indicates same or similar elements.

### DETAILED DESCRIPTION OF EMBODIMENTS

As briefed above, when using the probe card to test the electrical characters of traditional bonding pads on a wafer, the probe tips is very likely to leave some marks on the contact areas on the pads. As used herein, the term "probe mark" or "mark" refers to the foot print left behind the probe tips after contact with the pads. Those probe marks will probably cause problems in subsequent processes. For example, such probe marks might result in voids between the UBM layer and the solder formed over the UBM. As a result, the bump will be easily displaced or even dropped during the solder reflowing. Furthermore, in the case that the UMB plating (for example, nickel plating) process is applied for a copper column, the copper column may be crashed down by the stress. Therefore, the area on pad that will be used for bumping should be avoided any contact with the probe tips during the probe testing before bumping.

In general, embodiments of the present invention provide new solutions for electrical characteristic testing for flip chips. As will be apparent from the further discussions below, some pads on a flip chip are divided into two portions, one portion used for contact with the tips of the probe cards during the testing before bumping, while the other portion used for bumping without contact with the probe tips. In this way, the bumping portion on the bump is free of probe marks, thereby avoiding those problems caused by the marks on the pad left behind the probe tips. As such, the stability of the packaged chips may be improved without reducing the productivity. Now some exemplary embodiments of the present invention will be described with reference to the figures.

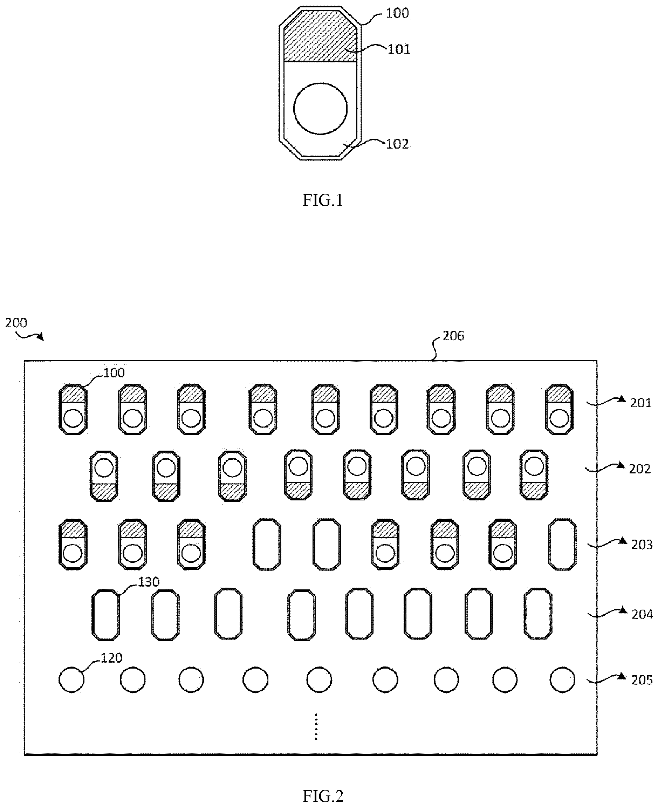

Reference is now made to FIG. 1, where the top view of a pad on a flip chip in accordance with examples useful for understanding the present invention. As shown, the pad 100 may be formed on a flip chip (not shown). The pad 100 is divided into two portions, namely, the first portion 101 and the second portion 102.

The first portion 101 is dedicated to the testing. More specifically, the first portion 101 of the pad 100 is used for contact with one or more tips of a probe device (e.g., a probe card) during a testing before the bumping on the pad. The probe card may detect various electrical characteristics of the pad 100 by contacting the first portion 101 with its tips. In subsequent bumping procedure, the portion 101 will not be used anymore. In this way, even if the probe tips leave one or more marks on the first portion 101, those marks will not cause voids between the UBM layer and the solder or any other problem existing in the prior art.

On the other hand, the second portion 102 of the pad 100 is dedicated to the bumping and subsequent processes. During the probe testing before the bumping, it is ensured that no probe tip touches the second portion 102. This may be done by appropriately configure and control the probe card or any other probe devices. If the pad 100 passes the electrical testing, then the second portion 102 may be used for bumping. Definitely the second portion will be entirely free of any probe marks, thereby successfully avoiding the potential problems.

The cross profile of the pad 100 may have an elongated shape. For example, the pad 100 may have a shape of long octagon, as shown in FIG. 1. Alternatively, rectangle, ellipse, or any other elongated shapes are also feasible. Having an elongated shape may be advantageous because the first portion for probe testing and the second portion for bumping may be physically separated from each other in a more effective manner. Of course, those skilled in the art would readily appreciate that the cross profile of the pad is not limited to the elongated shape. Instead, any appropriate shape may be used for the pad and the scope of the invention is not limited in that regard.

The area of the first portion 101 may be less than the area of the second portion 102. In this way, it is ensured that the pad 100 will have sufficient area for subsequent bumping, routing and other processes. Additionally, the area of the first portion 101 may be set greater than a predefined low threshold, such that there is sufficient area for contact with the probe tips. Those skilled in the art would readily appreciate that the area of the first and second portion may be set depending on various factors and specific requirements, and the scope of the invention is not limited in that regard.

As shown in FIG. 1, the first portion 101 is formed at one side of the pad 100, and the second portion 102 is formed at the opposite side of the pad 100. In this way, the probe card may be configured and controlled more effectively and efficiently to contact only the first portion 101 with its tips during testing. Of course, those skilled in the art would readily appreciate that any other arrangements of the first and second portions 101 and 102 are feasible. For example, the portion 102 may be formed at the middle of the pad 100, and the portion 101 may be further divided into two parts arranged at the two opposite side of the pad 100, respectively. Additionally, there may be one or more other portions in addition to the first and second portions 101 and 102. These additional portions may be reserved for any other uses. The scope of the invention is not limited in that regard.

Reference is next made to FIG. 2, where the top view of a flip chip in accordance with exemplary embodiments of the present invention is shown. As shown, the flip chip 200 comprises three sets of pads, namely the first set, the second set and the third set. The first set includes a plurality of pads 100 which are described above, for example, with reference to FIG. 1 Specifically, each pad 100 comprises a first portion for contact with one or more tips of a probe device during a testing before a bumping on the pad, and a second portion for the bumping without contact with the one or more tips during the testing.

The second set includes a plurality of pads, each of which is only used for bumping after the testing. That is, each and every pad 120 within the second set will not contact with any tips of the probe card during the electrical characteristic testing. In accordance with this configuration, the pads within the first set may undergo the probe testing as representative of the chip 200, while the second set of pads 120 will not be damaged by the probe tips.

The first set of pads 100 is formed in a first area of the chip 200, and the first area is proximate to an edge 206 of the chip 200. In FIG. 2, the first area in which the first set of pads 100 is formed includes the rows 201 and 202 as well as a part of the row 203. According to the invention, the rows 201 and 202 are the rows that most proximate to the edge 206 of the chip 200. This may be desired for the convenience and accuracy of the probe device's operations. Moreover, as shown from FIG. 2, the pads 100 within the first set may be formed in the first area with different orientations. For example, the pads 100 in the rows 201 and 202 are inversely orientated with respect to each other.

The second set of pads 120 is formed in a second area of the chip. Compared with the first area in which the first set of pads is formed, the second area is further from the edge 206 of the chip 200. For example, in FIG. 2, the second area includes the row 205, which is further from the edge 206 than the rows 201-203.

Furthermore, the flip chip 200 further comprises a third set of pads 130, each of the pads 130 in the third set is only used for probe. That is, the pads 130 within the third set may contact with the tips of the probe device during the testing, and the bumping process will not be performed on the pads 130.

The third set of pads 130 is formed in a third area between the first and second areas. In FIG. 2, the third area in which the third set is formed includes the fourth row 204 (corresponding to the "fifth row" in the claims) and parts of the third row 203 from the edge 206. In other words, the pads 130 are generally located between the pads 100 within the first set and the pads 120 within the second set.

The arrangement as shown in FIG. 2 may be beneficial. For example, if a plurality of pads 120, which are only used for bumping, are formed in the row 204, then the space for the probe card's operations will be limited. As a result, one has to use the vertical probe card, for example, with point tips, to conduct testing, which is more expensive. Instead, by forming some pads 130 which are only used for probe in the row 204 and the remaining part of the row 203, as shown in FIG. 2, the probe device may have more space to operate. Accordingly, the cantilever probe card which is more cost effective may be used to probe those pads formed in the rows 201-204 to successfully test the electrical characteristics of the chip 200. Moreover, the vertical probe card with flat tips may also be used in connection with embodiments of the present invention, which might be desired.

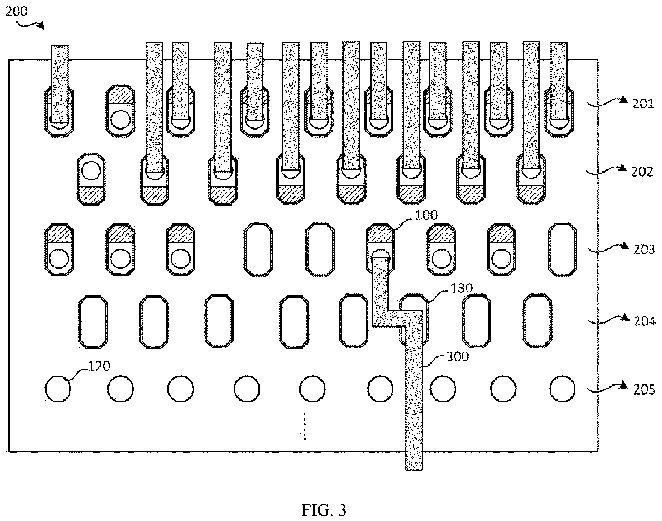

Additionally, the arrangement shown in FIG. 2 may ensure sufficient space for subsequent operations such as routing. For example, as shown in FIG. 3, when performing routing after the bumping on the flip chip 200, the trace 300 originated from a pad 100 in the row 203 may pass over a pad 130 in the row 204. This is possible because the pad 130 will only be used for probe but not for bumping or any other processes. In this way, more flexibility in routing and/or other processes may be obtained. In that regard, in accordance with some embodiments of the present invention, the pads 130 within the third set may include power pads, ground pads, or any other pads with no need of bumping.

Those skilled in the art would readily appreciate that the arrangement shown in FIG. 2 is exemplary and only for the purpose of illustration. Any other appropriate arrangements are feasible, and the scope of the present invention is not limited in that regard but is defined in the claims.

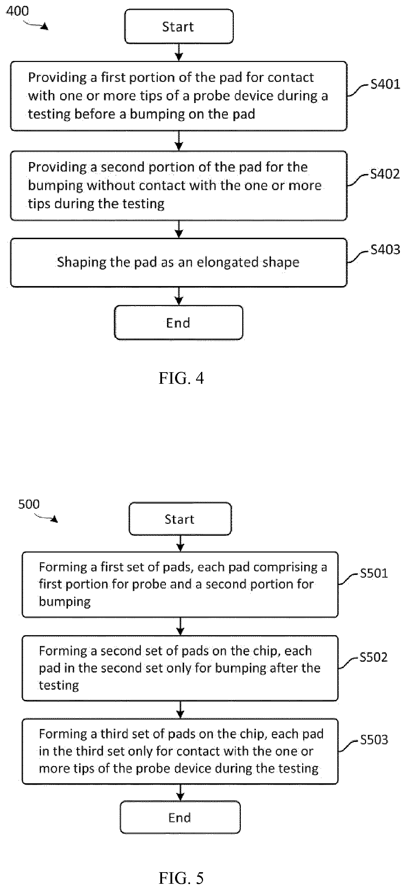

Now refer to FIG. 4, where the flowchart of a method for manufacturing a pad on a flip chip in accordance with examples useful for understanding the present invention is shown.

After the method 400 starts, at step S401, a first portion of the pad is provided for contact with one or more tips of a probe device during a testing before a bumping on the pad. In other words, as described above, the first portion will only be used for probe. No bumping process will be applied to the first portion of the pad later. Providing the first portion comprises forming the first portion at a side of the pad, for example, as shown in FIG. 1.

Next, the method 400 proceeds to step S402, where a second portion of the pad is provided for the bumping without contact with the one or more tips during the testing. As detailed above, it is ensured that the second portion will not contact with the probe tips during the testing and therefore is free of any probe tips. Providing the second portion comprises forming the second portion at the side opposite to the side at which the first portion is formed, for example, as shown in FIG. 1.

The area of the first portion is less than the area of the second portion. Further, the area of the first portion may be set greater than a predefined low threshold.

The method 400 may proceed to the optional step S403. At step S403, the pad may be shaped as an elongated shape, for example, a long octagon, a rectangle, or an ellipse. Any other shape factors are also feasible.

The method 400 ends after step S403. Those skilled in the art would readily appreciate that the method 400 may be used to manufacture the pad 100 as detailed above with reference to FIG. 1. Therefore, any features that are described above in connection to FIG. 1 are also applicable to the method 400 and are omitted herein.

FIG. 5 shows the flowchart of part of a method for manufacturing a flip chip in accordance with exemplary embodiments of the present invention.

After the method 500 starts, at step S501, a first set of pads is formed on the flip chip, each of the pads in the first set comprises a first portion for contact with one or more tips of a probe device during a testing before a bumping on the pad, and a second portion for the bumping without contact with the one or more tips during the testing. A pad in the first set has been described above with reference to FIG. 1, and may be manufactured according to the method 400 described above with reference to FIG. 4.

Forming the first set of pads comprises forming the first set of pads in a first area of the chip that is proximate to an edge of the chip.

Next the method 500 proceeds to step S502, where a second set of pads is formed on the chip, each of the pads in the second set only used for bumping after the testing. Forming the second set of pads comprises forming the second set of pads in a second area of the chip that is further from the edge than the first area.

The method 500 proceeds to the step S503. At step S503, a third set of pads is formed on the chip, each of the pads in the third set only used for contact with the one or more tips of the probe device during the testing. Forming the third set of pads comprises forming the third set of pads in a third area between the first and second areas in which the first and second sets of the pads are formed, respectively.

The illustrated method 500 ends after step S503, but the method according to the invention comprises steps of testing and forming solder bumps as defined in claim 2. Those skilled in the art would readily appreciate that the method 500 may be used to manufacture the chip 200 as detailed above with reference to FIGs. 2 and 3. Therefore, any features that are described above in connection to FIGs. 2 and 3 are also applicable to the method 500 and are omitted herein.

For the purpose of illustrating the principle of the present invention, some specific examples useful for understanding the invention and embodiments of the invention have been described above. However, it is noted that the described examples and embodiments in no sense limit the scope of the present invention.

While several specific implementation details are contained in the above discussions, these should not be construed as limitations on the scope of the invention as defined in the claims, but rather as descriptions of features that may be specific to particular examples or embodiments. Certain features that are described in this specification in the context of separate embodiments can also be implemented in combination in a single embodiment. Conversely, various features that are described in the context of a single embodiment can also be implemented in multiple embodiments separately or in any suitable sub-combination.

Similarly, while operations are depicted in the drawings in a particular order, this should not be understood as requiring that such operations be performed in the particular order shown or in sequential order, apart from the order specified in or implied by claim 2. In certain circumstances, multitasking and parallel formation of pads may be advantageous.

Various modifications, adaptations to the foregoing exemplary embodiments of this invention may become apparent to those skilled in the relevant arts in view of the foregoing description, when read in conjunction with the accompanying drawings. Furthermore, other embodiments of the inventions set forth herein will come to mind to one skilled in the art to which these embodiments of the invention pertain having the benefit of the teachings presented in the foregoing descriptions and the associated drawings.

Therefore, it is to be understood that the embodiments of the invention are not to be limited to the specific embodiments disclosed and that the scope of the invention is defined by the appended claims.

## Claims

1. A flip chip (200), comprising:
a first set of pads (100), each pad of the first set of pads (100) comprising:
a first pad portion (101) configured for only contact with one or more tips of a probe device during a testing before bumping on the pad of the first set of pads (100), and
a second pad portion (102) configured for only the bumping on the pad of the first set of pads (100) without contact with the one or more tips during the testing;
a second set of pads (120), each pad of the second set of pads (120) configured for only bumping on the pad of the second set of pads (120) after the testing; and
a third set of pads (130), each pad of the third set of pads (130) configured for only contact with one or more tips of the probe device during the testing,
wherein the first pad portions (101) and the pads of the third set of pads (130) have probe marks but no solder bumps thereon, and the second pad portions (102) and the pads of the second set of pads (120) have solder bumps but no probe marks thereon,
wherein the first set of pads (100) are formed in first and second rows (201, 202) and a part of a third row (203) in a first area of the flip chip (200) that is proximate to an edge of the flip chip (200), the second set of pads (120) are formed in a fourth row (205) in a second area of the flip chip (200) that is further from the edge than the first area, and the third set of pads (130) are formed in a fifth row (204) and another part of the third row (203) in a third area of the flip chip (200) between the first and second areas,
wherein the first and second rows (201, 202) are proximate to the edge,
wherein the fourth row (205) is further from the edge than the first and second rows (201, 202), and
wherein the third row (203) is disposed between the second row (202) and the fifth row (204), and the fifth row (204) is disposed between the third row (203) and the fourth row (205).

2. A method (500) for manufacturing a flip chip (200), comprising:
forming (S501) a first set of pads (100) on the flip chip (200), wherein forming each pad of the first set of pads (100) comprises:
providing a first pad portion (101) of the pad configured for only contact with one or more tips of a probe device during a testing before bumping on the pad of the first set of pads (100), and
providing a second pad portion (102) of the pad configured for only the bumping on the pad of the first set of pads (100) without contact with the one or more tips during the testing;
forming (S502) a second set of pads (120) on the flip chip (200), each pad of the second set of pads (120) configured for only bumping on the pad of the second set of pads (120) after the testing;
forming (S503) a third set of pads (130) on the flip chip (200), each pad of the third set of pads (130) configured for only contact with one or more tips of the probe device during the testing;
testing the flip chip (200), thereby causing probe marks on the first pad portions (101) and the pads of the third set of pads (130) but not on the second pad portions (102) and not on the pads of the second set of pads (120); and
after the testing, forming solder bumps on the second pad portions (102) and the pads of the second set of pads (120) but not on the first pad portions (101) and not on the pads of the third set of pads (130),
wherein the first set of pads (100) are formed in first and second rows (201, 202) and a part of a third row (203) in a first area of the flip chip (200) that is proximate to an edge of the flip chip (200), the second set of pads (120) are formed in a fourth row (205) in a second area of the flip chip (200) that is further from the edge than the first area, and the third set of pads (130) are formed in a fifth row (204) and another part of the third row (203) in a third area of the flip chip (200) between the first and second areas,
wherein the first and second rows (201, 202) are proximate to the edge,
wherein the fourth row (205) is further from the edge than the first and second rows (201, 202), and
wherein the third row (203) is disposed between the second row (202) and the fifth row (204), and the fifth row (204) is disposed between the third row (203) and the fourth row (205).

## Patentansprüche

1. Flip-Chip (200), umfassend:
einen ersten Satz von Kontaktstellen (100), wobei jede Kontaktstelle des ersten Satzes von Kontaktstellen (100) umfasst:
einen ersten Kontaktstellenabschnitt (101), der nur zum Kontaktieren mit einer oder mehreren Spitzen einer Sondenvorrichtung während eines Testens vor einem Bumping auf der Kontaktstelle des ersten Satzes von Kontaktstellen (100) konfiguriert ist, und
einen zweiten Kontaktstellenabschnitt (102), der nur zum Bumping auf der Kontaktstelle des ersten Satzes von Kontaktstellen (100) konfiguriert ist, ohne Kontakt mit der einen oder den mehreren Spitzen während des Testens;
einen zweiten Satz von Kontaktstellen (120), wobei jede Kontaktstelle des zweiten Satzes von Kontaktstellen (120) nur zum Bumping auf der Kontaktstelle des zweiten Satzes von Kontaktstellen (100) nach dem Testen konfiguriert ist; und
einen dritten Satz von Kontaktstellen (130), wobei jede Kontaktstelle des dritten Satzes von Kontaktstellen (130) nur zum Kontaktieren mit einer oder mehreren Spitzen der Sondenvorrichtung während des Testens konfiguriert ist,
wobei die ersten Kontaktstellenabschnitte (101) und die Kontaktstellen des dritten Satzes von Kontaktstellen (130) Sondenmarkierungen aber keine Lötbumps darauf aufweisen, und die zweiten Kontaktstellenabschnitte (102) und die Kontaktstellen des zweiten Satzes von Kontaktstellen (120) Lötbumps aber keine Sondenmarkierungen darauf aufweisen,
wobei der erste Satz von Kontaktstellen (100) in ersten und zweiten Reihen (201, 202) und einem Teil einer dritten Reihe (203) in einem ersten Bereich des Flip-Chips (200) ausgebildet ist, der sich in der Nähe einer Kante des Flip-Chips (200) befindet, der zweite Satz von Kontaktstellen (120) in einer vierten Reihe (205) in einem zweiten Bereich des Flip-Chips (200) ausgebildet ist, der weiter von der Kante entfernt ist als der erste Bereich, und der dritte Satz von Kontaktstellen (130) in einer fünften Reihe (204) und einem anderen Teil der dritten Reihe (203) in einem dritten Bereich des Flip-Chips (200) zwischen dem ersten und dem zweiten Bereich ausgebildet ist,
wobei die erste und die zweite Reihe (201, 202) in der Nähe des Randes liegen,
wobei die vierte Reihe (205) weiter von der Kante entfernt ist als die erste und zweite Reihe (201, 202), und
wobei die dritte Reihe (203) zwischen der zweiten Reihe (202) und der fünften Reihe (204) angeordnet ist, und die fünfte Reihe (204) zwischen der dritten Reihe (203) und der vierten Reihe (205) angeordnet ist.

2. Verfahren (500) zur Herstellung eines Flip-Chips (200), umfassend:
Ausbilden (S501) eines ersten Satzes von Kontaktstellen (100) auf dem Flip-Chip (200), wobei das Ausbilden jeder Kontaktstelle des ersten Satzes von Kontaktstellen (100) umfasst:
Bereitstellen eines ersten Kontaktstellenabschnitts (101) der Kontaktstelle, der nur zum Kontaktieren mit einer oder mehreren Spitzen einer Sondenvorrichtung während eines Testens vor einem Bumping auf der Kontaktstelle des ersten Satzes von Kontaktstellen (100) konfiguriert ist, und
Bereitstellen eines zweiten Kontaktstellenabschnitts (102) der Kontaktstelle, der nur zum Bumping auf der Kontaktstelle des ersten Satzes von Kontaktstellen (100) konfiguriert ist, ohne Kontakt mit der einen oder den mehreren Spitzen während des Testens;
Ausbilden (S502) eines zweiten Satzes von Kontaktstellen (120) auf dem Flip-Chip (200), wobei jede Kontaktstelle des zweiten Satzes von Kontaktstellen (120) nur zum Bumping auf der Kontaktstelle des zweiten Satzes von Kontaktstellen (100) nach dem Testen konfiguriert ist; und
Ausbilden (S503) eines dritten Satzes von Kontaktstellen (130) auf dem Flip-Chip (200), wobei jede Kontaktstelle des dritten Satzes von Kontaktstellen (130) nur zum Kontaktieren mit einer oder mehreren Spitzen der Sondenvorrichtung während des Testens konfiguriert ist;
Testen des Flip-Chips (200), wodurch Sondenmarkierungen auf den ersten Kontaktstellenabschnitten (101) und den Kontaktstellen des dritten Satzes von Kontaktstellen (130) aber nicht auf den zweiten Kontaktstellenabschnitten (102) und nicht auf den Kontaktstellen des zweiten Satzes von Kontaktstellen (120) verursacht werden; und
nach dem Testen, Ausbilden von Lötbumps auf den zweiten Kontaktstellenabschnitten (102) und den Kontaktstellen des zweiten Satzes von Kontaktstellen (120) aber nicht auf den ersten Kontaktstellenabschnitten (101) und nicht auf den Kontaktstellen des dritten Satzes von Kontaktstellen (130),
wobei der erste Satz von Kontaktstellen (100) in ersten und zweiten Reihen (201, 202) und einem Teil einer dritten Reihe (203) in einem ersten Bereich des Flip-Chips (200) ausgebildet ist, der sich in der Nähe einer Kante des Flip-Chips (200) befindet, der zweite Satz von Kontaktstellen (120) in einer vierten Reihe (205) in einem zweiten Bereich des Flip-Chips (200) ausgebildet ist, der weiter von der Kante entfernt ist als der erste Bereich, und der dritte Satz von Kontaktstellen (130) in einer fünften Reihe (204) und einem anderen Teil der dritten Reihe (203) in einem dritten Bereich des Flip-Chips (200) zwischen dem ersten und dem zweiten Bereich ausgebildet ist,
wobei die erste und die zweite Reihe (201, 202) in der Nähe des Randes liegen,
wobei die vierte Reihe (205) weiter von der Kante entfernt ist als die erste und zweite Reihe (201, 202), und
wobei die dritte Reihe (203) zwischen der zweiten Reihe (202) und der fünften Reihe (204) angeordnet ist, und die fünfte Reihe (204) zwischen der dritten Reihe (203) und der vierten Reihe (205) angeordnet ist.

## Revendications

1. Puce retournée (200) comprenant:
un premier ensemble de plots (100), chaque plot du premier ensemble de plots (100) comprenant:
une première portion de plot (101) configurée pour entrer en contact uniquement avec une ou plusieurs pointe(s) d'un dispositif de sonde pendant un test avant un bumping sur le plot du premier ensemble de plots (100), et
une deuxième portion de plot (102) configurée pour seulement le bumping sur le plot du premier ensemble de plots (100) sans contact avec ladite une ou lesdites plusieurs pointe(s) pendant le test;
un deuxième ensemble de plots (120), chaque plot du deuxième ensemble de plots (120) étant configuré pour seulement le bumping sur le plot du deuxième ensemble de plots (120) après le test; et
un troisième ensemble de plots (130), chaque plot du troisième ensemble de plots (130) étant configuré pour entrer en contact uniquement avec une ou plusieurs pointe(s) du dispositif de sonde pendant le test,
dans lequel les premières portions de plot (101) et les plots du troisième ensemble de plots (130) présentent des marques de sonde mais pas de bosses de soudure là-dessus, et les deuxièmes portions de plots (102) et les plots du deuxième ensemble de plots (120) présentent des bosses de soudure mais pas de marques de sonde là-dessus,
dans lequel le premier ensemble de plots (100) est formé dans une première et une deuxième rangées (201, 202) et une partie d'une troisième rangée (203) dans une première zone de la puce retournée (200), qui est proche d'un bord de la puce retournée (200), le deuxième ensemble de plots (120) est formé dans une quatrième rangée (205) dans une deuxième zone de la puce retournée (200), qui est plus éloignée du bord que la première zone, et le troisième ensemble de plots (130) est formé dans une cinquième rangée (204) et une autre partie de la troisième rangée (203) dans une troisième zone de la puce retournée (200) entre les première et deuxième zones,
dans lequel les première et deuxième rangées (201, 202) sont proches du bord,
dans lequel la quatrième rangée (205) est plus éloignée du bord que les première et deuxième rangées (201, 202), et
dans lequel la troisième rangée (203) est disposée entre la deuxième rangée (202) et la cinquième rangée (204), et la cinquième rangée (204) est disposée entre la troisième rangée (203) et la quatrième rangée (205).

2. Procédé (500) de fabrication d'une puce retournée (200), comprenant:
former (S501) un premier ensemble de plots (100) sur la puce retournée (200), dans lequel la formation de chaque plot du premier ensemble de plots (100) comprend:
fournir une première portion de plot (101) du plot qui est configurée pour entrer en contact uniquement avec une ou plusieurs pointe(s) d'un dispositif de sonde pendant un test avant un bumping sur le plot du premier ensemble de plots (100), et
fournir une deuxième portion de plot (102) du plot qui est configurée pour seulement le bumping sur le plot du premier ensemble de plots (100) sans contact avec ladite une ou lesdites plusieurs pointe(s) pendant le test;
former (S502) un deuxième ensemble de plots (120) sur la puce retournée (200), chaque plot du deuxième ensemble de plots (120) étant configuré pour seulement le bumping sur le plot du deuxième ensemble de plots (120) après le test;
former (S503) un troisième ensemble de plots (130) sur la puce retournée (200), chaque plot du troisième ensemble de plots (130) étant configuré pour entrer en contact uniquement avec une ou plusieurs pointe(s) du dispositif de sonde pendant le test;
tester la puce retournée (200), provoquant ainsi des marques de sonde sur les premières portions de plot (101) et les plots du troisième ensemble de plots (130) mais pas sur les deuxièmes portions de plot (102) et non pas sur les plots du deuxième ensemble de plots (120); et
après le test, former des bosses de soudure sur les deuxièmes portions de plot (102) et les plots du deuxième ensemble de plots (120) mais pas sur les premières portions de plot (101) et non pas sur les plots du troisième ensemble de plots (130),
dans lequel le premier ensemble de plots (100) est formé dans une première et une deuxième rangées (201, 202) et une partie d'une troisième rangée (203) dans une première zone de la puce retournée (200), qui est proche d'un bord de la puce retournée (200), le deuxième ensemble de plots (120) est formé dans une quatrième rangée (205) dans une deuxième zone de la puce retournée (200), qui est plus éloignée du bord que la première zone, et le troisième ensemble de plots (130) est formé dans une cinquième rangée (204) et une autre partie de la troisième rangée (203) dans une troisième zone de la puce retournée (200) entre les première et deuxième zones,
dans lequel les première et deuxième rangées (201, 202) sont proches du bord,
dans lequel la quatrième rangée (205) est plus éloignée du bord que les première et deuxième rangées (201, 202), et
dans lequel la troisième rangée (203) est disposée entre la deuxième rangée (202) et la cinquième rangée (204), et la cinquième rangée (204) est disposée entre la troisième rangée (203) et la quatrième rangée (205).
